# EUROPEAN PATENT APPLICATION

(11) **EP 2 763 341 A1**
(43) Date of publication of application: **06.08.2014**
(21) Application number: 13305118.5
(22) Date of filing: 01.02.2013
(51) Int. Cl.: H04J 14/02, H01S 5/00, H01S 3/00, H04B 10/50

(54) **DWDM Sources using a Laser based Frequency Comb with a Selective Modulator Array**

(71) Applicant: Alcatel Lucent, 75007 Paris (FR); COMMISSARIAT A L'ENERGIE ATOMIQUE ET AUX ENERGIES ALTERNATIVES, 75015 Paris (FR); u2t Photonics AG, 10553 Berlin (DE)
(72) Inventor: Lelarge, François, 75012 Paris (FR); Steffan, Andreas, 10717 Berlin (DE)
(74) Representative: MERH-IP Matias Erny Reichl Hoffmann

(57) **Abstract**

The present document relates to optical transmission systems. In particular, the present document relates to a transmitter for optical Wavelength Division Multiplex (WDM) signals, notably Dense WDM (DWDM) signals. A WDM source (200) configured to provide a plurality of optical WDM signals at a corresponding plurality of wavelengths is described. The WDM source (200) comprises a laser (201) configured to provide a plurality of optical continuous waves at the plurality of wavelengths, respectively. Furthermore, the WDM source (200) comprises an input waveguide (204, 404) configured to guide the plurality of optical continuous waves. In addition, the WDM source (200) comprises a modulator array (400) comprising a plurality of modulators (210) for modulating the plurality of optical continuous waves, respectively. A first modulator (210) of the plurality of modulators (210) is optically coupled to the input waveguide (204, 404), such that the first modulator (210) is traversed by the plurality of optical continuous waves. The first modulator (210) is operable in an on-state and an off-state, wherein in the on-state, the first modulator (210) is configured to modify the continuous wave at the first of the plurality of wavelengths, while substantially letting unaffected the continuous waves at the others of the plurality of wavelengths, and wherein in the off-state, the first modulator (210) is configured to substantially let unaffected the plurality of continuous waves.

## Description

The present document relates to optical transmission systems. In particular, the present document relates to a transmitter for optical Wavelength Division Multiplex (WDM) signals, notably Dense WDM (DWDM) signals.

For high speed optical transmission systems (e.g. at bit-rates in the range of 100Gb/s or above) the total bit-rate is typically split up into a pre-determined number N of transmission channels at different carrier wavelengths, wherein each transmission channel is modulated at M Gb/s. This may be referred to as wavelength division multiplex (WDM), and in the case of 400Gb/s, 40 WDM channels at 10Gb/s each, 10 WDM channels at 40Gb/s each, or 4 WDM channels at 100Gb/s each may be used. The N WDM channels may be provided by a series ofN hybrid or monolithically integrated lasers. This, however, leads to significant costs for such WDM transceivers.

In order to reduce the cost of such WDM sources (or DWDM sources), a frequency comb generated by a Fabry-Perot (FP) laser may be used. Such FP lasers may be configured to provide a plurality of distinct laser sources at a corresponding plurality of wavelengths. The plurality of distinct laser sources may be used to provide N WDM transmission channels. Nevertheless, there remains the technical problem of providing efficient means for independently modulating the laser light at the N wavelengths provided by the FP laser. In other words, in order to be able to use the frequency comb provided by an FP laser as a WDM source, an efficient way for modulating independently the different WDM channels is needed.

According to an aspect, a WDM source (e.g. a DWDM source) configured to provide a plurality of modulated optical WDM signals at a corresponding plurality of wavelengths is described. The plurality of wavelengths may be spaced by a fixed wavelength spacing, wherein the fixed wavelength spacing may correspond to a WDM grid according to ITU-T G.694. The WDM source may be used within a transmitter (also referred to as a transceiver) of an optical WDM transmission network. In particular, the WDM source may be used in transceivers used in optical access networks, such as passive optical networks (PONs).

The WDM source may comprise a laser configured to provide a plurality of optical continuous waves (CW) at the plurality of wavelengths, respectively. In particular, the laser may be configured to provide the plurality of continuous waves at the plurality of wavelengths, such that adjacent wavelengths of the plurality of wavelengths are spaced from one another by the fixed wavelength spacing. The laser may comprise a Fabry-Perot (FP) laser. In particular, the laser may comprise a mode-locked FP laser, thereby providing a wavelength comb with continuous waves at substantially equal power. Even more particularly, the laser may comprise a mode-locked laser based on quantum dashes or on a quantum dots active layer. Such lasers provide a particularly flat spectrum across a relatively wide frequency comb (comprising a relatively large number of wavelengths, e.g. more than 16 or 32).

Furthermore, the WDM source may comprise an input waveguide configured to guide the plurality of optical continuous waves. Typically, the input waveguide is a single mode waveguide which is coupled at one end to the laser to receive the plurality of optical continuous waves. Furthermore, the input waveguide may provide at the other end an output interface of the WDM source (e.g. for being coupled to a single mode fiber). The WDM source may provide the plurality of modulated WDM signals at the output interface of the WDM source.

In addition, the WDM source may comprise a modulator array comprising a plurality of modulators for modulating the plurality of optical continuous waves, respectively. In particular, each of the plurality of modulators may be configured to modulate a different one of the continuous waves. The plurality of modulators may be arranged alongside of the input waveguide. In particular, the plurality of modulators may be optically coupled to the input waveguide to receive some or all of the plurality of continuous waves. A first modulator of the plurality of modulators may be optically coupled to the input waveguide, such that the first modulator is traversed by some or all of the plurality of optical continuous waves. The first modulator may be operable in an on-state and an off state, in order to modulate the continuous wave at a first of the plurality of wavelengths. In particular, the first modulator may comprise a modulation section which allows the first modulator to be put into the on-state and/or into the off-state. By changing the first modulator between the on-state and the off-state in accordance to pre-determined data, the continuous wave at the first of the plurality of wavelengths may be modulated with the pre-determined data, thereby providing a modulated optical WDM signal at the first of the plurality of wavelengths.

When in the on-state, the first modulator may be configured to modify (e.g. attenuate) the continuous wave at the first of the plurality of wavelengths, while substantially letting unaffected (e.g. letting pass) the continuous waves at the others of the plurality of wavelengths. On the other hand, when in the off-state, the first modulator may be configured to substantially let unaffected or let pass (all of) the plurality of continuous waves. As such, the first modulator may be configured to individually modulate the continuous wave at the first wavelength, while leaving unaffected the continuous waves at the other wavelengths.

The first modulator may be configured to perform amplitude modulation of the continuous wave at the first wavelength, e.g. the first modulator may be configured to attenuate the continuous wave at the first wavelength, when in on-state and to let unaffected the continuous wave at the first wavelength, when in off-state. In particular, the first modulator may be configured to perform a multilevel amplitude modulation of the continuous wave at the first wavelength, thereby allowing the transmission of a plurality of bits / time slot. Alternatively or in addition, the first modulator may be configured to perform phase modulation and/or polarization modulation of the continuous wave at the first wavelength, while leaving unaffected the continuous waves at the other wavelengths. The amplitude, phase and/or polarization of the continuous wave at the first wavelength may be modified, when the first modulator is in on-state, and the amplitude, phase and/or polarization of the continuous wave at the first wavelength may be left unaffected, when the first modulator is in off-state.

The plurality of modulators may comprise a second modulator configured to individually modulate a second one of the plurality of continuous wave. In particular, the plurality of modulators may comprise modulators for individually modulating each of the plurality of continuous waves. The plurality of modulators may be configured to perform amplitude, phase and/or polarization modulation of the respective plurality of continuous waves (in a similar manner as the first modulator). As such, the modulator array may allow for an individual modulation of each of the plurality of continuous waves, without the need to demultiplex the plurality of continuous waves provided by the laser. As a result of this, a compact and cost efficient WDM source for individually modulated WDM signals can be provided.

The first modulator may comprise an optical resonator having a first on-resonance wavelength, when the first modulator is in on-state, and a first off-resonance wavelength, when the first modulator is in off-state. The first on-resonance wavelength may correspond to the first of the plurality of wavelengths. On the other hand, the first off-resonance wavelength may lie between the first of the plurality of wavelengths and a wavelength of the plurality of wavelengths directly adjacent to the first of the plurality of wavelengths, thereby leaving unaffected the plurality of continuous waves. In other words, the first off-resonance wavelength may be such that (all of) the plurality of continuous waves remains substantially unaffected. The on-off ratio between the attenuation, when the first modulator is in on-state and the attenuation, when the first modulator is in off-state, may be at least 20dB. Such an on-off ratio may be achieved by an appropriate design of the optical resonator of the first modulator.

In a similar manner, the plurality of modulators may comprise a second modulator with an optical resonator having a second on-resonance wavelength and a second off-resonance wavelength, wherein the second on-resonance wavelength is different from the first on-resonance wavelength and corresponds to a second one of the plurality of wavelengths provided by the laser. As such, a second modulator may be used to individually modulate a second continuous wave from the plurality of continuous waves. Overall, each of the plurality of modulators may comprise an optical resonator with an on-resonance wavelength tuned to a respective one of the plurality of wavelengths of the continuous waves.

In particular, the first modulator may comprise a first ring resonator. The first ring resonator may comprise a resonator loop having a first perimeter, wherein the first on-resonance wavelength and/or the first off-resonance wavelength depend on the first perimeter. In a similar manner, the second and/or all of the other modulators may comprise ring resonators with perimeters which are selected to provide the appropriate on-resonance wavelengths.

The first ring resonator may comprise a modulation section, wherein the modulation section is configured to change a resonance wavelength of the first ring resonator from the first on-resonance wavelength to the first off-resonance wavelength, or vice-versa, when applying a current to the modulation section, thereby putting the first modulator from the on-state to the off-state, or vice versa. In a similar manner, the second and/or the other modulators may comprise modulation sections for switching the modulator between the on-state and the off-state, thereby enabling the individual modulation of the continuous waves, i.e. thereby providing respective modulated optical signals. As such, the plurality of modulators may comprise respective modulation sections for individually controlling on-states and/or off-states of the plurality of modulators, thereby enabling the individual modulation of the continuous waves provided by the laser.

The first modulator and the other modulators may comprise a plurality of resonator loops. The use of a plurality of resonator loops may be beneficial to adjust the degree of attenuation (i.e. the Q factor) of the modulator, when in on-state.

The WDM source may further comprise an output waveguide (also referred to as a throughput waveguide) optically coupled to the plurality of modulators. The output waveguide may be positioned alongside of the plurality of modulators. The output waveguide may be positioned at an end of the plurality of modulators which is opposite to the end of the plurality of modulators at which the input waveguide is positioned. The output waveguide may be a single mode waveguide. Furthermore, the output waveguide may comprise the output interface of the WDM source for providing the modulated WDM signals. The use of an input waveguide (for inserting the continuous waves) and an output waveguide (for providing the modulated WDM signals) may be beneficial for increasing the on-off ratio of the modulators.

The WDM source may further comprises a thermal resistance section along the plurality of modulators. By way of example, the thermal resistance section may be arranged alongside of the input waveguide and/or of the output waveguide. The thermal resistance section may be configured to modify the first on-resonance wavelength of the first modulator, when applying a current to the thermal resistance section. As such, the thermal resistance section may be configured to tune the first on-resonance wavelength to the first of the plurality of wavelengths provided by the laser. In other words, the thermal resistance wavelength may be used to compensate for a manufacturing mismatch between the laser and the modulator array.

As indicated above, the plurality of modulators may have respective on-resonance wavelengths corresponding to respective ones of the plurality of wavelengths. The on-resonance wavelengths between directly adjacent ones of the plurality of modulators may be spaced by a fixed modulator spacing. The fixed modulator spacing typically corresponds to the wavelength spacing of the plurality of wavelengths provided by the laser. Typically, the first modulator (closest to the laser) modulates the continuous wave with the shortest wavelength, and the last modulator (at the highest distance from the laser) modulates the continuous wave with the longest wavelength. The thermal resistance section may exhibit a width which changes alongside of the plurality of modulators. In particular, the width of the thermal resistance section may increase or decrease with a gradient. The degree of the change of the width (i.e. the gradient) may depend on the fixed modulator spacing, thereby ensuring that a higher offset is applied to the resonance wavelengths of the modulators for longer wavelengths.

As such, in an example WDM source, each of the plurality of modulators may be optically coupled to the input waveguide, such that each of the plurality of modulators is traversed by some or all of the plurality of optical continuous waves. Each of the plurality of modulators may be operable in an on-state and an off-state. Furthermore, each of the plurality of modulators may be configured to modify (e.g. attenuate) the continuous wave at a respective one of the plurality of wavelengths, while substantially letting unaffected of letting pass the continuous waves at the others of the plurality of wavelengths, when in on-state. In addition, each of the plurality of modulators may be configured to substantially let pass or let unaffected (all of) the plurality of continuous waves, when in off-state.

As indicated above, the plurality of modulators may comprise a ring resonator. Alternatively or in addition, the plurality of modulators may comprise a photonic crystal resonator.

According to a further aspect a transceiver for a WDM network is described. The transceiver may comprise an optical transmitter comprising a WDM source as described in the present document. Furthermore, the optical transmitter may comprise a data interface for providing a plurality of data streams for transmission on a plurality of WDM channels respectively. The optical transmitter may be configured to modulate the plurality of modulators of the modulator array of the WDM source, in accordance to the plurality of data streams, respectively. This may be achieved by putting the modulators into on-states and off-states, in accordance to the plurality of data streams. As a result of this, a plurality of modulated WDM signals may be provided, wherein the plurality of WDM signals is indicative of the plurality of data streams, respectively.

It should be noted that the methods and systems including its preferred embodiments as outlined in the present patent application may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner.

The invention is explained below in an exemplary manner with reference to the accompanying drawings, wherein
Fig. 1 shows an example frequency comb provided by a mode-locked laser;
Fig. 2 shows a block diagram of an example array of modulators;
Fig. 3 illustrates an example response of a modulator;
Fig. 4 shows a block diagram of another example array of modulators;
Fig. 5 illustrates an example response of an array of modulators; and
Fig. 6 shows a block diagram of another example array of modulators.

As outlined in the introductory section, the present document relates to a cost efficient source for WDM signals comprising a plurality of wavelengths. The source may be referred to as a WDM source or specifically as a DWDM source. The WDM source may comprise an FP laser configured to provide a frequency comb which comprises a plurality of wavelengths that are spaced at a wavelength distance from one another. The wavelength distance (also referred to as the wavelength spacing) typically depends on the free spectral range (FSP) of the Fabry-Perot cavity of the FP laser.

The frequency comb of a FP laser typically does not match the ITU-T grid defined for WDM signals. The ITU-T grid specifies a fixed spacing (of e.g. 25GHz or 50Hz or 100GHz) between adjacent WDM channels. The mismatch of the frequency comb provided by a FP laser is due to the fact that the frequencies of the various modes of an FP laser typically fluctuate randomly. It is therefore proposed to use the frequency comb of a mode-locked laser, as a mode-locked laser may be tuned to ensure the exact matching with one of the ITU-T grids. Furthermore, a mode-locked laser typically provides a frequency comb having a relatively flat envelope over a range of around 15 wavelengths (for a 3dB envelope), thereby providing WDM sources having a homogeneous power distribution.

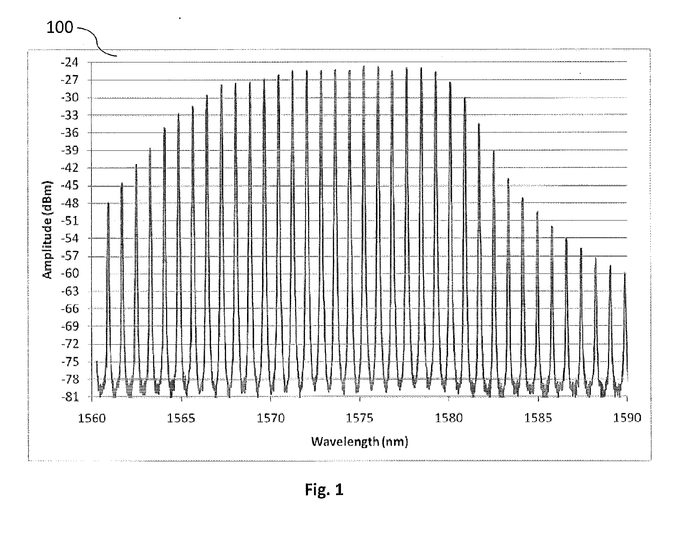

Fig. 1 shows an example frequency comb 100 provided by a mode-locked FP laser. The illustrated FP laser provides WDM wavelengths in the range of 1565nm to 1580nm (i.e. in the L-band). Different wavelength ranges (e.g. different optical bands such as the O band or the C band) may be provided by using FP lasers with different active material. The spacing between adjacent wavelengths of the frequency comb 100 may be adjusted by adjusting the length of the Fabry-Perot cavity, thereby adjusting the free spectral range (FSR).

As such, a mode-locked FP laser may be used to provide N continuous waves (CW) at N different wavelengths, wherein the N wavelengths match an ITU-T grid specified for WDM channels. A possible solution for modulating the N CWs may be to split up the different wavelengths using a demultiplexer (DMUX), to modulate the separated CWs externally using respective modulators, thereby yielding N optical signals at N different wavelengths, and to recombine the N modulated optical signals using a multiplexer (MUX). The DMUX, the modulators and the MUX may be implemented on InP (Indium Phosphate) for a monolithic integration or on Si (Silicon) for a hybrid integration. However, this solution is not cost-effective, due to the large size of the MUX and DMUX devices.

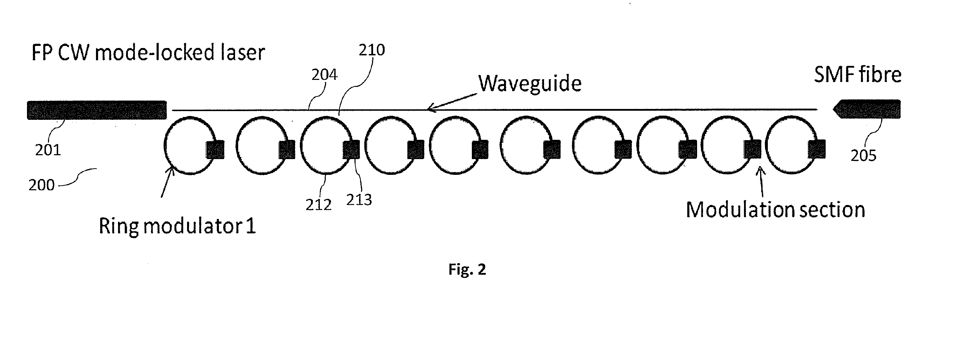

In the present document, it is proposed to combine the frequency comb 100 generated by a mode-locked laser with a modulator array. This is illustrated in Fig. 2 which shows the block diagram of an example WDM source 200 comprising a FP mode-locked laser 201 which is configured to provide a frequency comb 100, i.e. which is configured to provide a plurality of CWs at a corresponding plurality of different wavelengths. The frequency comb 100 is coupled into a single (i.e. into one unique) waveguide 204 (also referred to as the input waveguide in the present document). The waveguide may e.g. be implemented on Si or InP. Along the waveguide 204, an array of N modulators 210 may be provided. The modulators 210 may be arranged along the input waveguide 204 such that the plurality of CWs from the laser 201 is coupled into the modulators 210. By way of example, the modulators 210 may be implemented as ring resonators or Photonic Crystal (PhC) resonators. In the illustrated example of Fig. 2 an array of ring resonators is depicted. Each ring resonator 210 comprises a waveguide loop 212 (also referred to herein as a resonator loop), having a pre-determined perimeter, and a modulation section 213. The waveguide loop 212 may be used to tune the resonator wavelength to one of the plurality of wavelengths provided by the laser 201. The modulation section 213 may be used to modulate the resonator wavelength, thereby modulating the CW at the wavelengths that the modulator 210 is tuned to. The modulated WDM signals are then coupled from the waveguide 204 to a single mode fiber (SMF) 205 for transmission to a corresponding optical receiver.

The array of modulators 210 may be viewed as a series of optical notch filters having stopbands at respective wavelengths of the plurality of wavelengths of the CWs. The input waveguide 204 ensures that the CWs are provided to each of the notch filters (i.e. to each of the modulators 210).

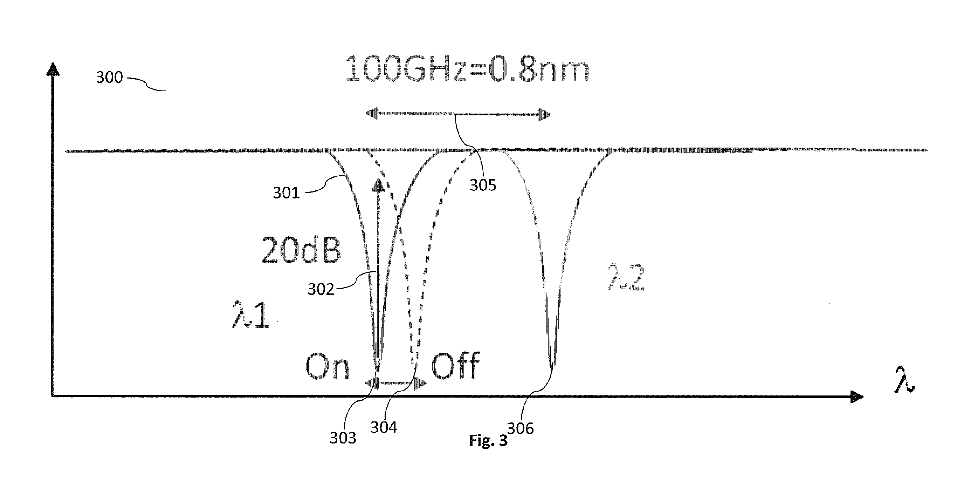

Fig. 3 illustrates the function of a modulator 210 in further detail. In particular, Fig. 3 illustrates the frequency response 300 of an example modulator 210. The modulator 100 exhibits a resonance frequency at λ₁ 303 (referred to as the on-resonance frequency or the on-resonance wavelength), wherein in case of a ring resonator, the resonance frequency may be tuned by the perimeter of the waveguide loop 212. As a result of the resonance frequency, the CW provided by the laser 201 is attenuated at the resonance frequency. This is illustrated by the stopband 301 of the frequency response 300.

The resonance frequency 303 of the modulator 210 may be modified to an adjacent resonance frequency 304 (referred to as the off-resonance frequency or the off-resonance wavelength) using e.g. the modulation section 213. The modulation section 213 may e.g. be implemented as a thermal resistance, such that the modification of the temperature at the modulation section 213 changes the resonance frequency of the modulator 210 from the on-resonance frequency 303 to the off-resonance frequency 304 (or vice versa). By way of example, when using a filter with a Q factor of about 60000, an on-off ratio 302 of about 20dB with FSR 25GHz may be obtained. As a result of the shifting of the resonance frequency to the off-resonance frequency 304, the CW provided by the laser 201 is not attenuated anymore (or attenuated to a lower extent) compared to the attenuation applied at the on-resonance frequency 303. Hence, the CW may be modulated by switching the modulator 210 between on and off using the modulator section 213.

In other words, the modulator 210 exhibits an on-state with the on-resonance wavelength 303 and an off-state with the off-resonance wavelength 304. The CW at the on-resonance wavelength may be modulated by changing the modulator 210 between on-states and off-states, in accordance to the data which is to be modulated onto the CW.

As such, it is proposed to use an array of modulators 210, each modulator 210 having a respective on-resonance wavelength 303 tuned to the wavelength of a respective one of the wavelengths provided by the laser 201. As a consequence, each modulator 210 of the array will be designed to modulate only one channel and will let the others channels unaffected. In Fig. 3 the on-resonance wavelength λ₂ 306 of a second modulator 210 of the array of modulators is shown. In the illustrated example, the on-resonance wavelength λ₂ 306 of the second modulator 210 is spaced by a modulator spacing 305 (100GHz or 0.8nm in the illustrated example) from the on-resonance wavelength λ₁ 303 of the first modulator 210. In case of ring resonators, the modulator spacing 305 may be modified by appropriately modifying the difference in perimeter of the different modulators 210. By way of example, a modulator spacing 305 of 100GHz may be achieved by selecting a perimeter of 12µm for the first modulator 210 and a perimeter of 12.35µm for the second modulator 210.

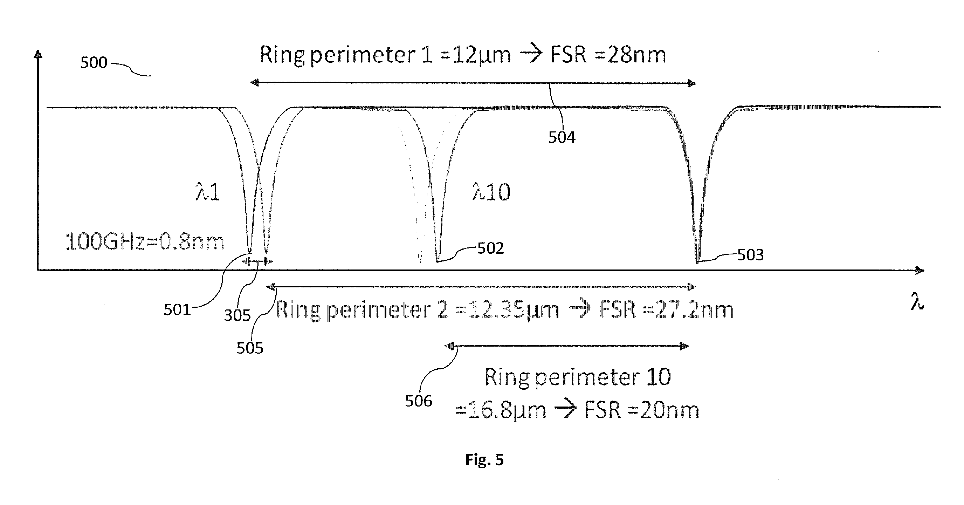

The modulators 210 are typically based on resonators having a pre-determined FSR. The pre-determined FSR may limit the number of channels which may be modulated by an array of modulators 210, as illustrated in Fig. 5. Fig. 5 shows the frequency response 500 of an example array of modulators 210 comprising N=10 modulators 210. As such, the array of modulators 210 is configured to independently modulate 10 CWs provided by the laser 201. Fig. 5 shows the on-resonance frequencies λ₁ to λ₁₀ 501, 502 of the array of modulators 210. The different on-resonance frequencies are spaced from one another with the modulator spacing 305 (100GHz in the illustrated example). The first modulator (for on-resonance frequency λ₁) is implemented using a waveguide loop 212 having a perimeter of 12µm. The resulting ring resonator exhibits an FSR 504 of 28nm which means that the frequency response 300 of the first modulator exhibits another on-resonance frequency 503 which is spaced from the first on-resonance frequency 501 by 28nm. In the illustrated example, the second modulator (for on-resonance frequency λ₂) is implemented using a waveguide loop 212 having a perimeter of 12.35µm which leads to an FSR 505 of 27.2nm and a further on-resonance frequency 503. The tenth modulator (for on-resonance frequency λ₁₀) is implemented using a waveguide loop 212 having a perimeter of 16.8µm which leads to an FSR 506 of 20nm and a further on-resonance frequency 503.

Hence, it can be seen that the number of modulators 210 in an array, i.e. the number of WDM channels which can be modulated independently, is typically limited by the FSR of the modulators. For instance, an array of ring resonators (12µm perimeter→ FSR=28nm) allows to modulate up to 32 channels with 50GHz spacing at 40Gb/s.

The modulator array may be tuned to the wavelengths of the comb 100 provided by the laser 100 by design using e.g. different ring diameters or ring perimeters for the modulators 210 along the waveguide 204. As illustrated in Fig. 5, the ring perimeter may be changed, thereby changing the on-resonance frequencies 501, 502 of the modulators 210.

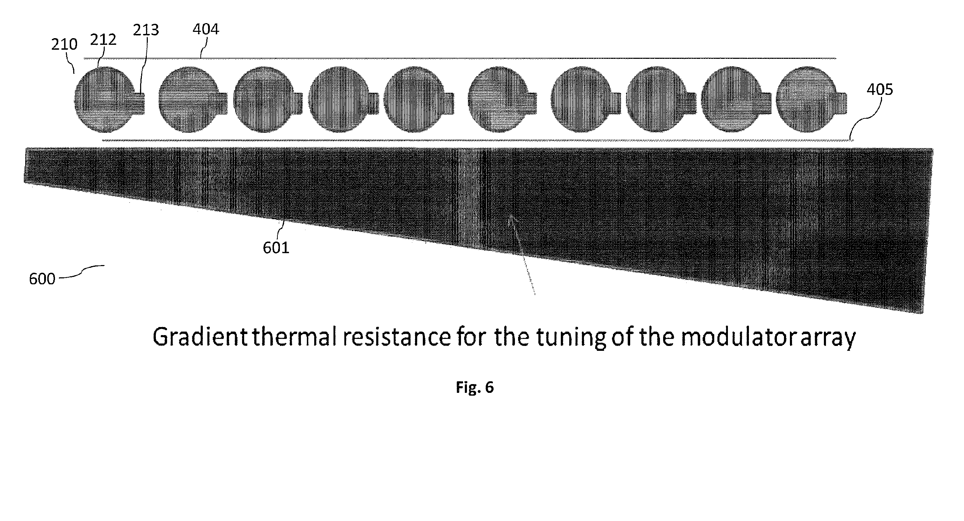

Alternatively or in addition, the tuning (e.g. the fine tuning) of the array of modulators 210 may be achieved by using a thermal resistance having a specific shape as illustrated in Fig.6. Fig. 6 shows an array 600 of modulators 210 comprising a thermal resistance section 601. The thermal resistance section 601 is implemented along the modulators 210 of the modulator array. The thermal resistance section 601 may be configured to modify the index of the material of the modulators 210, thereby modifying the resonance wavelengths of the modulators 210. Furthermore, the thermal resistance section 601 may exhibit a gradient which takes into account the difference of the resonance frequencies 501, 502 of the modulators 210. The gradient thermal resistance section 601 may be used to tune the modulator array to the frequency comb 100. In particular, the injected current as well as a Peltier cooler may be used for a fine tuning of the first modulator 210 to the first wavelength of the comb 100. By way of example, the Peltier cooler may be used to tune the first modulator 210 to the first wavelength of the frequency comb, and the gradient of the thermal resistance section 601 may be used to align the frequency spacing between the modulators 210 to the frequency spacing of the frequency comb. The shape of the thermal resistance section 601 may depend on the modulator spacing 305 between adjacent resonance wavelengths of adjacent modulators 210. In particular, the shape of the thermal resistance section 601 may be such that the shift applied to the second resonance wavelength is higher than the shift applied to the first resonance wavelength by an amount which corresponds to the modulators spacing 305 (e.g. 100GHz). Furthermore, the shape of the section 601 may be such that the same is ensured for the other resonance wavelengths of the array of modulators.

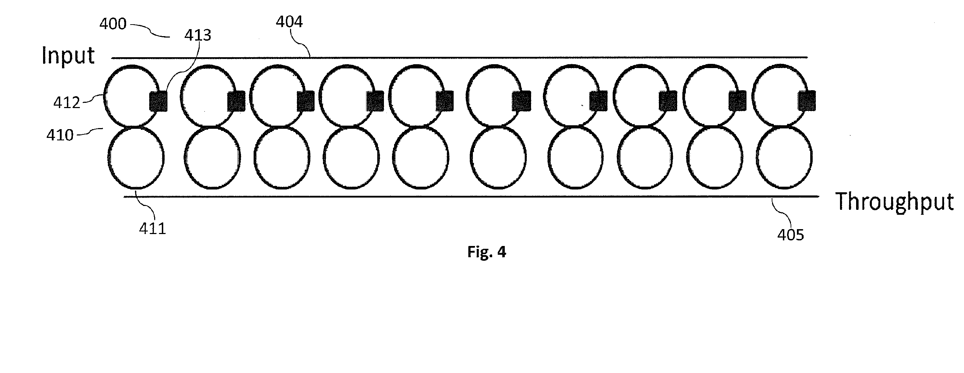

Fig. 4 shows a block diagram of another example array 400 of modulators 410. The array 400 comprises an input waveguide 404 and a throughput waveguide 405. The modulators 410 comprise a primary loop 412 with a modulator section 413. Furthermore, the modulators 410 comprise a secondary loop 411. The separate input waveguide 404 and throughput waveguide 405 may be used to increase the on-off ratio 302 of the modulators 410. Furthermore, the multiple ring structure comprising a plurality of loops 411, 412 typically provides a higher degree of flexibility for the design of the frequency response 300 of the modulator 410.

The array of modulators described in the present document may be designed for various modulator spacings 305. In particular, the modulator spacing 305 may be adapted to various ITU grids (e.g. in the range 50-100GHz). Furthermore, the number of channels which can be modulated may be varied (e.g. from 4 to 32 channels). In addition, the range of the wavelengths which are to be modulated may be adapted by selecting appropriate resonance wavelengths (e.g. for the O, C, L-band). This may be achieved e.g. by changing the perimeters of the loops of the rings of the modulators. The array of modulators may be implemented on Si or on InP.

As outlined above, the modulator array may comprise ring resonators and/or photonic crystal modulators which are tuned to different resonance wavelengths. Multiple ring configurations and/or separate input/output waveguides may be used to design the modulator response (notably with respect to the on-off ratio and with respect to the wavelength window in order to include an increased number of frequency modes within a channel). By way of example, a modulator may be designed to modulate a plurality of wavelengths provided by the FP laser, e.g. 5 wavelengths spaced by 10GHz. As such, a subset of wavelengths may be modulated jointly and may be used as a transmission channel.

In the present document, a WDM source comprising a FP laser in combination with an array of modulators has been described. The array of modulators provides an efficient way to benefit from the unique properties of a frequency comb generated by a quantum dot /dash based laser. The WDM source described in the present document is highly compact (implemented e.g. on a surface of 1000µm*500µm for 10 channels of 10Gb/s) as compared to a MUX/DEMUX solution with 10 modulators (implemented e.g. on a surface of 5000µm*5000µm). As such, the DWDM source described herein is highly compact and compatible with high output power. Furthermore, the described DWDM source is compatible with a 10*10Gb/s WDM system, and could be extended to up to 32 channels at a 50GHz spacing with a modulation of up to 40Gb/s, thereby providing a Tb/s WDM system.

It should be noted that the description and drawings merely illustrate the principles of the proposed methods and systems. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Finally, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A WDM source (200) configured to provide a plurality of modulated optical WDM signals at a corresponding plurality of wavelengths, the WDM source (200) comprising
- a laser (201) configured to provide a plurality of optical continuous waves at the plurality of wavelengths, respectively;
- an input waveguide (204, 404) configured to guide the plurality of optical continuous waves; and
- a modulator array (400) comprising a plurality of modulators (210) for modulating the plurality of optical continuous waves, respectively; wherein a first modulator (210) of the plurality of modulators (210) is optically coupled to the input waveguide (204, 404), such that the first modulator (210) is traversed by the plurality of optical continuous waves; wherein the first modulator (210) is operable in an on-state and an off-state to modulate the continuous wave at a first of the plurality of wavelengths; wherein in the on-state, the first modulator (210) is configured to modify the continuous wave at the first of the plurality of wavelengths, while substantially letting unaffected the continuous waves at the others of the plurality of wavelengths; wherein in the off-state, the first modulator (210) is configured to substantially let unaffected the plurality of continuous waves.

2. The WDM source (200) of claim 1, wherein
- the first modulator (210) comprises an optical resonator having a first on-resonance wavelength (303), when the first modulator (210) is in on-state, and a first off-resonance wavelength (304), when the first modulator (210) is in off-state; and
- the first on-resonance wavelength (303) corresponds to the first of the plurality of wavelengths.

3. The WDM source (200) of claim 2, wherein the first off-resonance wavelength (304) lies between the first of the plurality of wavelengths and a wavelength of the plurality of wavelengths directly adjacent to the first of the plurality of wavelengths.

4. The WDM source (200) of any of claims 2 to 3, wherein
- the first modulator (210) comprises a first ring resonator;
- the first ring resonator comprises a resonator loop (212) having a first perimeter; and
- the first on-resonance wavelength and the first off-resonance wavelength depend on the first perimeter.

5. The WDM source (200) of claim 4, wherein
- the first ring resonator comprises a modulation section (213);
- the modulation section (213) is configured to change a resonance wavelength of the first ring resonator from the first on-resonance wavelength to the first off-resonance wavelength, or vice-versa, when applying a current to the modulation section (213), thereby putting the first modulator (210) from the on-state to the off-state, or vice versa.

6. The WDM source (200) of any of claims 4 to 5, wherein the first modulator (210) comprises a plurality of resonator loops (411, 412).

7. The WDM source (200) of any previous claim, further comprising an output waveguide (405) optically coupled to the plurality of modulators (210).

8. The WDM source (200) of any of claims 2 to 7, further comprising a thermal resistance section (601) along the plurality of modulators (210); wherein the thermal resistance section (601) is configured to modify the first on-resonance wavelength (303) of the first modulator (210), when applying a current to the thermal resistance section (601).

9. The WDM source (200) of claim 8, wherein
- the plurality of modulators (210) have respective on-resonance wavelengths (303) corresponding to respective ones of the plurality of wavelengths;
- the on-resonance wavelengths (303) between directly adjacent ones of the plurality of modulators (210) are spaced by a fixed modulator spacing (305);
- the thermal resistance section (601) exhibits a width which changes along the plurality of modulators (210); and
- a degree of the change of the width depends on the fixed modulator spacing (305).

10. The WDM source (200) of any previous claim, wherein
- each of the plurality of modulators (210) is optically coupled to the input waveguide (204, 404), such that each of the plurality of modulators (210) is traversed by the plurality of optical continuous waves;
- each of the plurality of modulators (210) is operable in an on-state and an off-state;
- each of the plurality of modulators (210) is configured to modify the continuous wave at a respective one of the plurality of wavelengths, while substantially letting unaffected the continuous waves at the others of the plurality of wavelengths, when in on-state; and
- each of the plurality of modulators (210) is configured to substantially let unaffected the plurality of continuous waves, when in off-state.

11. The WDM source (200) of any previous claim, wherein the plurality of modulators (210) comprise one or more of: a ring resonator or a photonic crystal resonator.

12. The WDM source (200) of any previous claim, wherein the plurality of modulators (210) comprise respective modulation sections (213) for individually controlling on-states and/or off-states of the plurality of modulators (210).

13. The WDM source (200) of any previous claim, wherein
- the laser (201) comprises a Fabry-Perot laser; and/or
- the laser (201) comprises a mode-locked laser.

14. The WDM source (200) of any previous claim, wherein the laser (201) is configured to provide the plurality of continuous waves at a plurality of wavelengths, such that adjacent wavelengths of the plurality of wavelengths are spaced from one another by a fixed wavelength spacing.

15. The WDM source (200) of claim 14, wherein the fixed wavelength spacing corresponds to a WDM grid according to ITU-T G.694.
